# EUROPEAN PATENT APPLICATION

(11) **EP 3 923 292 A1**
(43) Date of publication of application: **15.12.2021**
(21) Application number: 20876871.3
(22) Date of filing: 10.06.2020
(51) Int. Cl.: G11C 29/40

(54) **TEST CIRCUIT AND MEMORY CHIP USING THE TEST CIRCUIT**

(30) Priority: 16.10.2019 CN 201910981722
(71) Applicant: Changxin Memory Technologies, Inc., Hefei, Anhui 230000 (CN)
(72) Inventor: WANG, Jia, Hefei, Anhui 230000 (CN); ZHANG, Liang, Hefei, Anhui 230000 (CN); LI, Hongwen, Hefei, Anhui 230000 (CN)
(74) Representative: Lavoix
(86) International application number: PCT/CN2020/095339
(87) International publication number: WO 2021/073128

(57) **Abstract**

The present invention provides a test circuit and a memory chip. The test circuit is used for reading compressed data of a memory. The test circuit comprises a number M of storage blocks, wherein M is an even number greater than or equal to 2. A number N of the M storage blocks form a storage set, wherein N is an even number greater than or equal to 2 and less than or equal to M, and M is an integral multiple of N. The test circuit is characterized by further comprising compressed data reading units. One compressed data reading unit corresponds to one storage set. The each compressed data reading unit is connected to N storage blocks in the corresponding storage set. The compressed data reading units receive a compressed data reading command and address information, and read data in the N storage blocks according to the compressed data reading command and the address information. The present invention has advantages that the size of the memory chip is not additionally increased and test time can be greatly reduced.

## Description

### CROSS REFERENCE

This application claims priority to Chinese Patent Application No. 201910981722.2, titled "TEST CIRCUIT AND MEMORY CHIP USING TEST CIRCUIT" and filed on October 16, 2019, the entire contents of which are incorporated herein by reference.

### TECHNICAL FIELD

The present disclosure relates to the field of integrated circuit, and more particularly, to a test circuit and a memory chip using the test circuit.

### BACKGROUND

For DRAM chips, an array of chips may have manufacturing defects, so during a test phase, engineers need to find every defect in the array to ensure that all the defects are repaired.

Taking an LPDDR4 as an example, generally two test circuits are employed to find the defects in the array. One test circuit is an all-bank compression read architecture. Its advantage is that the time required to test a single DRAM chip is short, but its disadvantage is that a die size needs to be increased to store a compressed data reading circuit and 128 Lbus signal lines (signal lines specially configured to transmit compressed data), and four test data output ports are needed. Another test circuit is a one-bank compression read architecture, its advantage is to use its own Gbus signal line (a signal line configured to transmit normal data of a DRAM storage array, and also configured to transmit compressed data during a compressed data reading test) to complete the function of reading the compressed data, having no need to increase the die size, and only needing one test data output port. Its disadvantage is that long time is required to test the single DRAM chip.

Therefore, a new type of test circuit is urgently needed to overcome the above defects to meet the test requirements.

### SUMMARY

A technical problem to be solved by the present disclosure is to provide a test circuit and a memory chip using the test circuit, which can significantly reduce test time while not additionally increasing a size of the memory chip.

To solve the above problem, the present disclosure provides a test circuit for reading compressed data of a memory. The test circuit includes M storage blocks, wherein the M is an even number greater than or equal to 2. N storage blocks of the M storage blocks constitute a storage group, where N is an even number greater than or equal to 2 and less than or equal to M, and M is an integral multiple of N. The test circuit further includes compressed data reading units. Each of compressed data reading units corresponds to one of the storage groups. The compressed data reading unit is connected to the N storage blocks in the corresponding storage group. The compressed data reading unit receives a compressed data reading command and address information, and reads data in the N storage blocks according to the compressed data reading command and the address information.

Further, the M storage blocks are distributed in at least one odd-numbered column and at least one even-numbered column. At least one storage block in the odd-numbered column and at least one storage block in the even-numbered column constitute the storage group.

Further, the test circuit also includes at least one test data output port. The at least one test data output port is connected to the compressed data reading units through at least one compressed data bus.

Further, each of the at least one test data output port is connected to at least two of the compressed data reading units through a compressed data bus.

Further, the number of the at least one test data output port is two, each of the at least one test data output port is connected to four of the compressed data reading units through the compressed data bus.

Further, the compressed data bus is an eight-bit bus.

Further, the M is 32 and the N is 4.

Further, the 32 storage blocks are distributed in eight rows and four columns. The four columns include a first odd-numbered column, a first even-numbered column, a second odd-numbered column, and a second even-numbered column. The storage group comprises four storage blocks that are distributed in two rows and two columns. The two columns are a combination of the first odd-numbered column and the first even-numbered column or a combination of the second odd-numbered column and the second even-numbered column. Four compressed data reading units are provided between the first odd-numbered column and the first even-numbered column, and four compressed data reading units are provided between second the odd-numbered column and the second even-numbered column.

Further, the four compressed data reading units between the first odd-numbered column and the first even-numbered column are connected to one test data output port by an eight-bit compressed data bus, and four compressed data reading units between the second odd-numbered column and the second even-numbered column are connected to another test data output port by an eight-bit compressed data bus.

The present disclosure also provides a memory chip, which includes a data read-write bus, and further includes the aforementioned test circuit. The compressed data reading units are arranged below the data read-write bus on the memory chip.

Further, the data read-write bus occupies a first preset chip area in the memory chip, and the compressed data reading unit occupies a second preset chip area in the memory chip. The compressed data reading units are arranged below the data read-write bus on the memory chip, and the second preset area is less than the first preset area.

Further, a projection of the compressed data reading units on a chip substrate is covered by a projection of the data read-write bus on the chip substrate.

In the test circuit provided by the present disclosure, one compressed data reading unit corresponds to a plurality of storage blocks, which can significantly reduce test time while not additionally increase a size of the memory chip.

### BRIEF DESCRIPTION OF THE DRAWINGS

FIG. 1 is a schematic structural diagram of a test circuit according to a first embodiment of the present disclosure;
FIG. 2 is a schematic structural diagram of the test circuit according to a second embodiment of the present disclosure; and
FIG. 3 is a timing drive diagram of the test circuit according to the second embodiment of the present disclosure.

### DETAILED DESCRIPTION

Embodiments of a test circuit and a memory chip using the test circuit provided by the present disclosure are described below in detail with reference to the accompanying drawings.

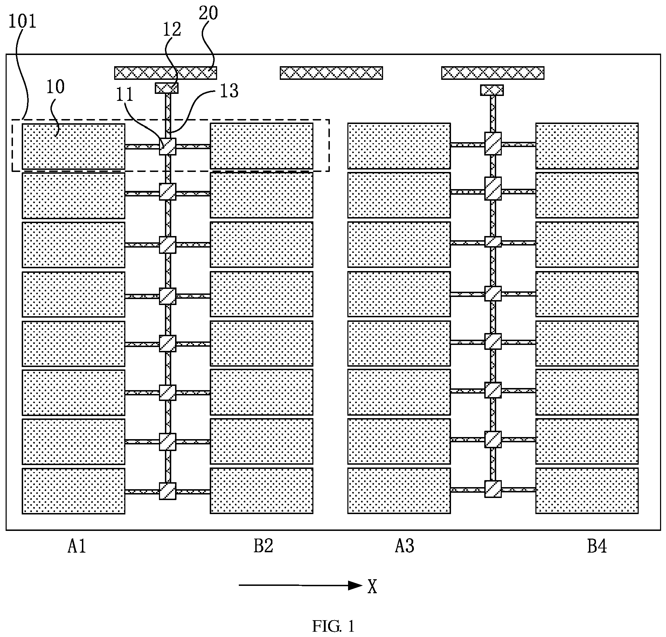

The test circuit provided by the present disclosure is configured to read compressed data of a memory. FIG. 1 is a schematic structural diagram of the test circuit according to a first embodiment of the present disclosure. With reference to FIG. 1, the test circuit includes M storage blocks 10. M is an even number greater than or equal to 2. In this embodiment, M is equal to 32. That is, the test circuit includes 32 storage blocks 10. In other embodiments of the present disclosure, the number of the storage blocks 10 may be other values. N storage blocks 10 constitute one storage group 101. N is an even number greater than or equal to 2 and less than or equal to M, and M is an integral multiple of N.

Further, the M storage blocks 10 may be distributed in at least one odd-numbered column and at least one even-numbered column. With reference to FIG. 1, in this embodiment, the M storage blocks 10 are distributed in two odd-numbered columns and two even-numbered columns. Specifically, the M storage blocks 10 are distributed in a first odd-numbered column A1, a second odd-numbered column A3, a first even-numbered column B2, and a second even-numbered column B4. The odd-numbered columns and the even-numbered columns are alternately distributed. That is, the arrangement of the columns formed by the storage blocks 10 is sequentially as below: the first odd-numbered column A1, the first even-numbered column B2, the second odd-numbered column A3, and the second even-numbered column B4. It is to be understood that in other embodiments of the present disclosure, the M storage blocks 10 may also form other numbers of odd-numbered columns and even-numbered columns, respectively.

At least one storage block 10 in the odd-numbered column and at least one storage block 10 in the even-numbered column constitute the storage group 101. In this embodiment, N is equal to 2. That is, one storage block 10 in the odd-numbered column and one storage block 10 in the even-numbered column constitute the storage group 101. Preferably, in order to facilitate the arrangement of the test circuit, two storage blocks 10 in the storage group 101 are arranged adjacently. As shown in FIG. 1, two storage blocks 10 adjacent in a horizontal direction (X direction) constitute the storage group 101. In other embodiments of the present disclosure, N may also be other numerical values, as long as M is an integral multiple of N.

The test circuit also includes compressed data reading units 11. One of the compressed data reading units 11 corresponds to one of the storage groups 101. That is, the number of the compressed data reading units 11 is equal to that of the storage groups 101. In this embodiment, the storage blocks are divided into 16 storage groups, and the number of the compressed data reading units 11 is 16.

The compressed data reading unit 11 is connected to the N storage blocks 10 in the corresponding storage group 101. In this embodiment, the compressed data reading unit 11 is respectively connected to one storage block 10 in the odd-numbered column and one storage block 10 in the even-numbered column.

The compressed data reading unit 11 receives a compressed data reading command and address information, and reads data in the N storage blocks 10 according to the compressed data reading command and the address information. The compressed data reading command and the address information may be sent out by a control module of the memory. The address information is configured for providing an address of the storage block 10 to be read to the compressed data reading unit 11, such that the compressed data reading unit 11 performs a reading operation on the corresponding storage block according to the address information. Specifically, if the address information corresponds to the address of the first storage block 10 in the first odd-numbered column A1, the compressed data reading unit 11 performs the reading operation on the first storage block 10 in the first odd-numbered column A1. If the address information corresponds to the address of the first storage block 10 in the first even-numbered column B2, the compressed data reading unit 11 performs the reading operation on the first storage block 10 in the first even-numbered column B2.

In the test circuit provided by the present disclosure, one compressed data reading unit corresponds to at least two storage blocks. Compared with the existing technologies, the test circuit provided by the present disclosure can significantly reduce test time while not additionally increase a size of the memory chip.

Further, the test circuit also includes at least one test data output port 12. The at least one test data output port 12 is connected to the compressed data reading units 11 through at least one compressed data bus 13. Data read by the compressed data reading units 11 is transmitted through the at least one compressed data bus 13 to the at least one test data output port 12 for data collection and analysis. The compressed data bus 13 is an eight-bit bus.

Further, the memory has a plurality of data input/output ports 20. In other embodiments of the present disclosure, the test circuit may reuse the data input/output ports 20 of the memory as the test data output ports 12 to save wiring space and improve an integration level.

Further, each of the at least one test data output port 12 is connected to at least two of the compressed data reading units 11 through a compressed data bus 13. In this embodiment, the number of the at least one test data output port 12 is two, and each of the at least one test data output port 12 is connected to eight of the compressed data reading units 11 through the compressed data bus 13. Specifically, the eight compressed data reading units 11 corresponding to the first odd-numbered column A1 and the first even-numbered column B2 share the same test data output port 12, and the eight compressed data reading units 11 corresponding to the second odd-numbered column A3 and the second even-numbered column B4 share the same test data output port 12.

The present disclosure also provides a second embodiment of the test circuit. The difference between the second embodiment and the first embodiment lies in that the number of the storage blocks contained in the storage group and the number of the compressed data reading units are different.

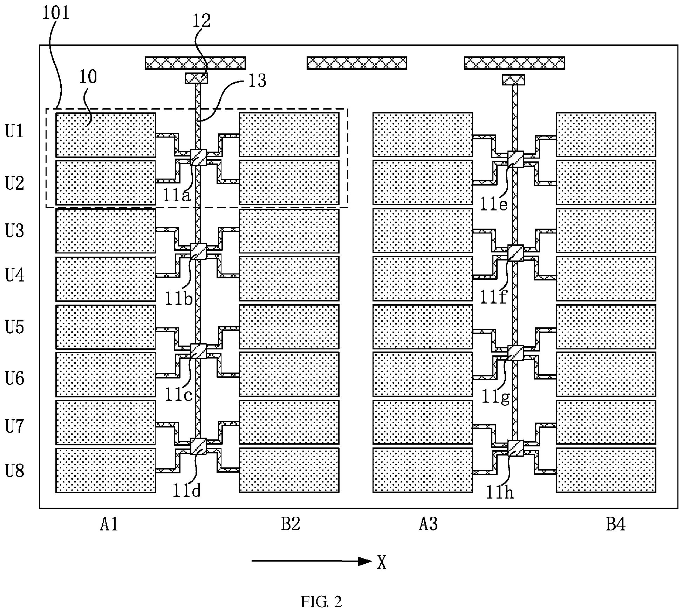

FIG. 2 is a schematic structural diagram of the test circuit according to the second embodiment of the present disclosure. With reference to FIG. 2, in this second embodiment, M is equal to 32. That is, the test circuit includes 32 storage blocks 10. N is equal to 4. That is, 4 storage blocks 10 constitute the storage group 101.

Specifically, in the second embodiment, the 32 storage blocks are distributed in eight rows and four columns. The four columns include the first odd-numbered column A1, the first even-numbered column B2, the second odd-numbered column A3, and the second even-numbered column B4. The 4 storage blocks included in one storage group 101 are distributed in two rows and two columns, and the two columns include a combination of the first odd-numbered column A1 and the first even-numbered column B2 or a combination of the second odd-numbered column A3 and the second even-numbered column B4. The two rows are two adjacent rows. For example, the four storage blocks are distributed in the first row U1 and the second row U2, or the third row U3 and the fourth row U 4, or the fifth row U5 and the sixth row U6, or the seventh row U7 and the eighth row U8.

Four compressed data reading units 11 are provided between the first odd-numbered column A1 and the first even-numbered column B2, which are 11a, 11b, 11c, and 11d respectively. Four compressed data reading units 11 are provided between the second odd-numbered column A3 and the second even-numbered column B4, which are 11e, 11f, 11g, and 11h respectively. The compressed data reading unit 11a is connected to the storage blocks 10 in the first row U1 and the second row U2 of the first odd-numbered column A1 and the first even-numbered column B2. The compressed data reading unit 11b is connected to the storage blocks 10 in the third row U3 and the fourth row U4 of the first odd-numbered column A1 and the first even-numbered column B2. The compressed data reading unit 11c is connected to the storage blocks 10 in the fifth row U5 and the sixth row U6 of the first odd-numbered column A1 and the first even-numbered column B2. The compressed data reading unit 11d is connected to the storage blocks 10 in the seventh row U7 and the eighth row U8 of the first odd-numbered column A1 and the first even-numbered column B2. The compressed data reading unit 11e is connected to the storage blocks 10 in the first row U1 and the second row U2 of the second odd-numbered column A3 and the second even-numbered column B4. The compressed data reading unit 11f is connected to the storage blocks 10 in the third row U3 and the fourth row U4 of the second odd-numbered column A3 and the second even-numbered column B4. The compressed data reading unit 11g is connected to the storage blocks 10 in the fifth row U5 and the sixth row U6 of the second odd-numbered column A3 and the second even-numbered column B4. The compressed data reading unit 11h is connected to the storage blocks 10 in the seventh row U7 and the eighth row U8 of the second odd-numbered column A3 and the second even-numbered column B4.

Further, in the second embodiment of the present disclosure, the number of the at least one test data output port 12 is two, and one test data output port 12 is connected to the four compressed data reading units through the compressed data bus 13. That is, the compressed data reading units between the first odd-numbered column A1 and the first even-numbered column B2 are connected to a same test data output port 12 through an eight-bit compressed data bus 13. The compressed data reading units between the second odd-numbered column A3 and the second even-numbered column B4 are connected to a same test data output port 12 through an eight-bit compressed data bus 13.

A working method of the test circuit provided by the present disclosure is described below by taking the storage group 101 composed of the storage block A1-UI corresponding to the first odd-numbered column A1 and the first row U1, the storage block A1-U2 corresponding to the first odd-numbered column A1 and the second row U2, the storage block B2-UI corresponding to the first even-numbered column B2 and the first row U1 and the storage block B2-U2 corresponding to the first even-numbered column B2 and the second row U2 as an example. The compressed data reading unit 11a corresponding to the storage group 101 receives a compressed data reading command and address information, where the address information is an address of the storage block A1-UI. The compressed data reading unit 11a reads data in the storage block A1-UI, and the read data is transmitted to the test data output port 12 through the compressed data bus 13. The storage block A1-UI, the storage block A1-U2, the storage block B2-UI and the storage block B2-U2 belong to the same storage group 101. Therefore, after reading the data in the storage block A1-UI, the compressed data reading unit 11a may read, in sequence, the data in the storage block B2-UI, the data in the storage block A1-U2, and the data in the storage block B2-U2. These data may be transmitted, in sequence, to the test data output port 12 through the compressed data bus 13. After all the data of these storage blocks in the storage group 101 is read, data in the next storage group is read and transmitted.

In this embodiment, the compressed data reading units between the first odd-numbered column A1 and the first even-numbered column B2 and the compressed data reading units between the second odd-numbered column A3 and the second even-numbered column B4 are respectively connected to different test data output ports, such that they can read data simultaneously.

The above merely describes one working method of the test circuit. Other working methods may also be adopted without departing from the principle of the present disclosure. For example, data of the storage blocks in the odd-numbered columns in the storage group is first read, and then data of the storage blocks in the even-numbered columns in the storage group is read.

In the second embodiment of the present disclosure, the test circuit strikes a better balance between the memory size, the test time and the number of the test data output ports 12. The test circuit provided by the present disclosure can significantly reduce the test time while not increase the memory size.

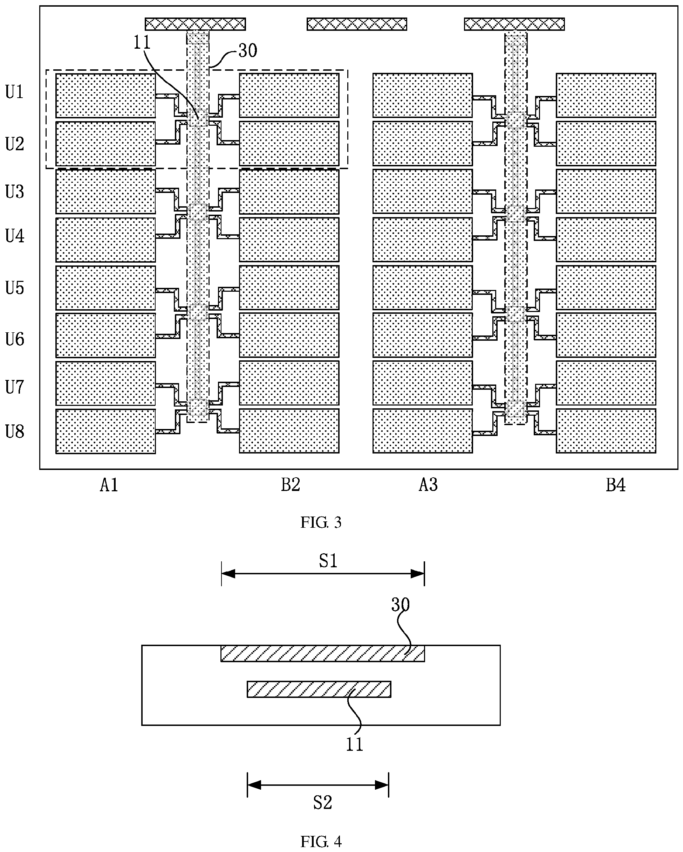

The present disclosure also provides a memory chip. The memory chip includes a data read-write bus and the above-mentioned test circuit. FIG. 3 is a schematic diagram of the data read-write bus and the test circuit in the memory chip. In FIG. 3, the data read-write bus is schematically drawn with broken lines. With reference to FIG. 3, in the memory chip, the compressed data reading units 11 are arranged below the data read-write bus 30. FIG. 4 is a schematic diagram showing a relative position between the data read-write bus and the compressed data reading unit in a direction perpendicular to the memory chip. With reference to FIG. 4, in the direction perpendicular to the memory chip, the compressed data reading unit 11 is positioned below the data read-write bus 30.

In the structure of the memory chip, the data read-write bus inevitably occupies a certain chip region, while the data read-write bus is vacant and is not used. The memory chip of the present disclosure uses the region below the data read-write bus 30 to place the compressed data reading units 11, such that the compressed data reading units 11 are prevented from occupying extra space of the memory chip, thereby avoiding a problem of increasing the area of the memory chip due to the arrangement of the compressed data reading unit.

Further, with continued reference to FIG. 4, the data read-write bus 30 occupies a first preset chip area S1 in the memory chip, and the compressed data reading units 11 occupy a second preset chip area S2 in the memory chip. The second preset area S2 is less than the first preset area S1. Therefore, the compressed data reading units can be further prevented from occupying the extra space of the memory chip.

Further, with continued reference to FIG. 4, a projection of the compressed data reading units 11 on a chip substrate is covered by a projection of the data read-write bus 30 on the chip substrate. That is, the second preset area S2 of the compressed data reading units 11 is completely within the range of the first preset chip area S1 of the data read-write bus 30. The compressed data reading units do not occupy at all a region beyond a vertical direction of the data read-write bus. Therefore, it is completely avoided the problem of increasing the size of the memory chip due to the arrangement of the compressed data reading units.

The above descriptions are merely the preferred embodiments of the present invention. It should be noted that those of ordinary skill in the art may make several improvements and modifications without departing from the principle of the present invention, and these improvements and modifications should also be considered as in the protection scope of the present invention.

## Claims

1. A test circuit for reading compressed data of a memory, wherein the test circuit comprises M storage blocks, wherein M is an even number greater than or equal to 2; N storage blocks of the M storage blocks constitute a storage group, N being an even number greater than or equal to 2 and less than or equal to M, M being an integral multiple of N; wherein the test circuit further comprises:
compressed data reading units, wherein each of the compressed data reading units corresponds to one of the storage groups;
wherein the compressed data reading unit is connected to the N storage blocks of the corresponding storage group, the compressed data reading unit is configured to receive a compressed data reading command and address information, and to read data in the N storage blocks according to the compressed data reading command and the address information.

2. The test circuit of claim 1, wherein the M storage blocks are distributed in at least one odd-numbered column and at least one even-numbered column, at least one storage block in the odd-numbered column and at least one storage block in the even-numbered column constituting the storage group.

3. The test circuit of claim 1, further comprising:
at least one test data output port, wherein the at least one test data output port isconnected to the compressed data reading units through at least one compressed data bus.

4. The test circuit of claim 3, wherein each of the at least one test data output port is connected to at least two of the compressed data reading units through a compressed data bus.

5. The test circuit of claim 4, wherein a number of the at least one test data output port is two, each of the at least one test data output port being connected to four of the compressed data reading units through the compressed data bus.

6. The test circuit of claim 3, wherein the compressed data bus is an eight-bit bus.

7. The test circuit of claim 3, wherein M is 32, and N is 4.

8. The test circuit of claim 7, wherein the 32 storage blocks are distributed in eight rows and four columns, wherein the four columns comprise a first odd-numbered column, a first even-numbered column, a second odd-numbered column, and a second even-numbered column;
wherein the storage group comprises four storage blocks that are distributed in two rows and two columns, wherein the two columns are a combination of the first odd-numbered column and the first even-numbered column, or a combination of the second odd-numbered column and the second even-numbered column;
wherein four compressed data reading units are provided between the first odd-numbered column and the first even-numbered column; and
wherein four compressed data reading units are provided between the second odd-numbered column and the second even-numbered column.

9. The test circuit of claim 8, wherein the four compressed data reading units between the first odd-numbered column and the first even-numbered column are connected to one test data output port by an eight-bit compressed data bus, and the four compressed data reading units between the second odd-numbered column and the second even-numbered column are connected to another test data output port by an eight-bit compressed data bus.

10. A memory chip, comprising a data read-write bus, wherein the memory chip further comprises the test circuit of any one of the claims 1 to 9, and the compressed data reading units are arranged below the data read-write bus on the memory chip.

11. The memory chip of claim 10, wherein the data read-write bus occupies a first preset chip area in the memory chip, and the compressed data reading units occupy a second preset chip area in the memory chip, wherein the second preset area is less than the first preset area.

12. The memory chip of claim 10, wherein a projection of the compressed data reading units on a chip substrate is covered by a projection of the data read-write bus on the chip substrate.
